# EUROPEAN PATENT APPLICATION

(11) **EP 4 841 280 A1**
(43) Date of publication of application: **18.11.2026**
(21) Application number: 25177091.3
(22) Date of filing: 16.05.2025
(51) Int. Cl.: G01R 31/3835

(54) **METHOD FOR DETECTING AN ANOMALOUS BATTERY CELL IN A VEHICLE, METHOD FOR MONITORING A BATTERY PACK OF A VEHICLE, DATA PROCESSING APPARATUS, COMPUTER PROGRAM, COMPUTER-READABLE STORAGE MEDIUM, AND VEHICLE**

(71) Applicant: Volvo Car Corporation, 405 31 Göteborg (SE)
(72) Inventor: PETTERSSON, Johnny, 40531 Götheborg (SE)
(74) Representative: Kransell & Wennborg KB

(57) **Abstract**

The disclosure relates to a method for detecting an anomalous battery cell (24) in a vehicle (10). The method comprises obtaining first data (D1) comprising a plurality of data items indicative of a voltage of the battery cell (24) within a first time period. The method further comprises obtaining a measure of a central tendency of the first data (D1). Moreover, the method comprises designating a data item of the first data (D1) as potentially indicative of an anomaly if an absolute difference between the data item and the measure of the central tendency is greater than or equal to a margin. Furthermore, the method comprises obtaining second data (D2) indicative of a number of data items associated with the first time period that are designated as potentially indicative of an anomalous battery cell (24) and/or indicative of a total difference of the data items differing from the measure of the central tendency by at least the margin. Finally, the method comprises designating the battery cell (24) as anomalous if the second data (D2) exceeds a number threshold and/or a total difference threshold. The disclosure also relates to a method for monitoring a battery pack (14) of a vehicle (10). The disclosure is also directed to a data processing apparatus (22), to a computer program (32), to a computer-readable storage medium (30), and to a vehicle (10).

## Description

### TECHNICAL FIELD

The present disclosure relates to a method for detecting an anomalous battery cell in a vehicle.

Moreover, the present disclosure relates to a method for monitoring a battery pack. The battery pack comprises a plurality of battery cells.

Furthermore, the present disclosure is directed to a data processing apparatus, to a computer program and to a computer-readable storage medium.

Additionally, the present disclosure relates to a vehicle.

### BACKGROUND ART

Vehicles, in particular electric vehicles, comprise battery packs, e.g. a traction battery for driving the vehicle, a starter battery for starting a drivetrain or an auxiliary battery for powering auxiliary units of the vehicle. An electric performance of a battery pack of a vehicle may decay over time. This may be due to anomalies of battery cells that the battery pack comprises. Anomalies of battery cells may, for example, be caused by chemical and/or mechanical ageing processes or by a mechanical impact onto the battery cell.

An anomaly, e.g. a malfunction or an already detectable future malfunction, in one battery cell of the battery pack may cause further anomalies in adjacent battery cells of the battery pack through thermal and/or electrical coupling between the battery cells. It is desirable to detect an anomalous battery cell in a battery pack as early as possible in order to be able to repair or replace anomalous battery cells and in order to prevent a spread of the anomaly to further battery cells of the battery pack.

### SE:TOP

### SUMMARY

It is therefore an objective of the present disclosure to provide an improved method for detecting an anomalous battery cell.

The problem is at least partially solved or alleviated by the subject matter of the independent claims of the present disclosure, wherein further examples are incorporated in the dependent claims.

According to a first aspect, there is provided a method for detecting an anomalous battery cell. The method comprises:
- obtaining first data comprising a plurality of data items indicative of a voltage of the battery cell within a first time period,
- obtaining a measure of a central tendency of the first data,
- designating a data item of the first data as potentially indicative of an anomaly if an absolute difference between the data item and the measure of the central tendency is greater than or equal to a margin,
- obtaining second data indicative of a number of data items associated with the first time period that are designated as potentially indicative of an anomalous battery cell and/or indicative of a total difference of the data items differing from the measure of the central tendency by at least the margin, and
- designating the battery cell as anomalous if the second data exceeds a number threshold and/or a total difference threshold.

Obtaining the first data may be understood as receiving or determining the first data. The first data comprises a plurality of data items indicative of a voltage of the battery cell within the first time period. The first data may be based on measurements, i.e. the first data may comprise a plurality of data items, each resulting from a measurement of a voltage of the battery cell within the first time period. In an example, the voltage of the battery cell may be a cell voltage during charging of the battery cell or just after charging of the battery cell has been completed. Obtaining the measure of the central tendency of the first data may be understood as receiving or determining the measure of the central tendency of the first data. It is further understood that the central tendency of the first data refers to the first time period. In other words, the central tendency of the first data is determined from data items of the first data associated with the first time period.

A data item of the first data is designated as potentially indicative of an anomaly of the battery cell if it differs from the measure of the central tendency by an absolute amount that is greater than or equal to the margin. The margin may be predefined. It is emphasized that the margin as such is not necessarily an absolute margin or an absolute threshold but may depend on the value of the measure of the central tendency of the first data and/or on further characteristics such as a scatter in the first data. The margin may be a non-directional or a directional margin. A non-directional margin is understood as extending on either side, i.e. above and below the measure of the central tendency of the first data. A directional margin is understood as extending only on one side, i.e. either above or below the measure of the central tendency of the first data. In an example, the margin is a directional margin extending from the measure of the central tendency of the first data towards the direction of zero.

Similar to the first data, obtaining the second data may be understood as receiving or determining the second data. In a first variant, the second data is indicative of a number of data items of the first data that are designated as potentially indicative of an anomalous battery cell. In other words, in the first variant, the second data is indicative of a count of data items associated with the first time period that are designated as potentially indicative of an anomalous battery cell, i.e. how many of the data items are designated as potentially indicative of an anomalous battery cell. In a second variant, the second data is indicative of a total difference of the data items of the first data that differ from the measure of the central tendency by at least the margin. The total difference may be understood as an accumulation of all differences between data items of the first data that are designated as potentially indicative of an anomalous battery cell and the measure of the central tendency of the first data. In other words, the total difference may be understood as a sum of all differences between data items of the first data that differ from the measure of the central tendency by at least the margin. The battery cell is designated as anomalous if, in the first variant, the second data exceeds a number threshold, and/or if, in the second variant, the second data exceeds a total difference threshold. The first variant and the second variant may come as alternatives or may be combined, i.e. used as conjunctive requirements to designate a battery cell as anomalous. In simplified words, the method counts and/or accumulates variations of the first data from its measure of the central tendency. This has the effect that a battery cell may be designated as anomalous without comparing its voltage to a voltage of a different battery cell. This excludes systematic errors in comparison between different battery cells that may lead to inaccurate designations of the battery cell comprising an anomaly. Thus, a reliability of a designation of a battery cell as anomalous is increased.

In an example, the measure of the central tendency of the first data comprises an arithmetic mean, a geometric mean and/or a median of the first data. In other words, the measure of the central tendency may comprise an arithmetic mean, a geometric mean and/or a median of the plurality of data items indicative of the voltage of the battery cell within the first time period. Using an arithmetic mean, a geometric mean and/or a median of the first data as a reference for determining if a data item of the first data is potentially indicative of an anomalous battery cell has the effect that isolated deviations in voltage of the battery cell do not significantly affect the reference for determining if a data item of the first data is potentially indicative of an anomalous battery cell. In other words, a robustness of the method for detecting an anomalous battery cell is enhanced.

In an example, the margin is defined as an absolute voltage margin, as a voltage margin relative to the measure of the central tendency of the first data and/or as a voltage margin relative to a scatter in the first data. Additionally or alternatively, the margin may be defined as an absolute voltage. Using an absolute voltage is a simple and reliable way to detect whether a data item of the first data is potentially indicative of an anomalous battery cell. In particular, voltage drops below a particular absolute voltage may be seen as a reliable indicator of a potentially anomalous battery cell. An absolute margin relative to the measure of the central tendency of the first data as margin takes a level of cell voltage that results from a given level of charge into account when determining if the battery cell shows an anomaly or functions properly. A voltage margin relative to a scatter in the first data may be understood as a voltage margin expressed based on a multiple of a measure of a scatter in the first data. The measure of the scatter in the first data may for example comprise a standard deviation of the first data. The margin may be defined by an absolute voltage or an absolute voltage margin from the measure of the central tendency corrected by a multiple of a measure of a scatter in the first data. Defining the margin based on a scatter in the first data has the effect that the margin may adapt to usual fluctuations in voltage of the battery cell that occur during use of the battery cell. This reduces false positive and false negative designations of the battery cell as anomalous.

In an example, the method further comprises varying the number threshold and/or the total difference threshold for detecting different anomaly types. In other words, different number thresholds and/or different total difference thresholds may be suitable for detecting different anomaly types of the battery cell.

Anomaly types of the battery cell may comprise tabs, which are connected to electrically and/or chemically active layers in the battery cell, i.e. to a cathode or to an anode, that are torn. Torn tabs of a battery cell may occur due to ageing and/or vibrations that the battery cell is subject to over its lifetime. A further failure mode of the battery cell may comprise a failure of a measurement node that measures a current, the voltage and/or a temperature of the respective battery cell. Moreover, anomalies in the chemistry of the battery cell such as an amount of lithium plating of its electrodes or a capacity of how much lithium the cathode can supply and how much lithium the anode can take up may be a form of an anomaly of the battery cell that may be distinguished by varying the number threshold and/or the total difference threshold. Finally, electric shortcuts in the battery cell, for example due to penetration by an external physical solid may be discernible from other anomalies of the battery cell by varying the number threshold and/or the total difference threshold.

In an example, the second data is accumulated over a second time period, wherein the second time period is longer than the first time period. This may mean that second data indicative of a number of data items associated with the second time period that are designated as potentially indicative of an anomalous battery cell is accumulated over the second time period. Additionally or alternatively, this may mean that second data indicative of a total difference of data items differing from the measure of the central tendency by at least the margin is accumulated over the second time period. It is understood that when the second data is accumulated over a second time period that is longer than the first time period, the second data is obtained based on a plurality of first time periods. Thus, for each first time period within the second time period, a separate measure of a central tendency of the first data is obtained. A particular data item of the first data is designated as potentially indicative of an anomaly if an absolute difference between the particular data item and the measure of the central tendency that corresponds to the first time period that the particular data item originates from is greater than or equal to the margin. In simplified words, a comparison of a data item from the first data to the central tendency of the first data is independently conducted based on a plurality of separate first time periods. The accumulation of the second data over the second time period covers the plurality of separate first time periods. This has the effect that only sporadically occurring voltage phenomena, which may be indicative of an anomalous battery cell, may be processed on a broader and, thus, on a more reliable statistical basis. This enhances detection capabilities of the method when it comes to detecting anomalies that only express themselves seldomly in fluctuations in the voltage of the battery cell.

In an example, the accumulation comprises an application of a reduction factor. In case the second time period is longer than the first time period, an observation window for counting or accumulating data items that are designated as potentially indicative of an anomalous battery cell is longer than one first time period. Thus, the number of data items and/or the accumulated sum of data items that are designated as potentially indicative of an anomalous battery cell will naturally be higher than when only using one first time period as the observation window. The reduction factor, which may be between 0 and 1, may account for this such that a similar or an identical number threshold as for a single first time period may be applied for the step of designating the battery cell as anomalous. Additionally or alternatively, a similar or an identical total difference threshold may be applied for the step of designating the battery cell as anomalous.

In an example, the reduction factor is proportional to a relation of a duration of the first time period and a duration of the second time period. More precisely, the reduction factor may be directly proportional to the relation of the duration of the first time period and the duration of the second time period. For example, if the second time is twice as long as the first time period, the reduction factor may be 1/2. In another example, if the second time period is three times as long as the first time period, the reduction factor may be 1/3. Thus, the reduction factor being proportional to a relation of the duration of the first time period and the duration of the second time period allows normalizing the number of data items from the second time period that are designated as potentially indicative of an anomalous battery cell to the duration of the first time period. Additionally or alternatively, the reduction factor being proportional to a relation of the duration of the first time period and the duration of the second time allows normalizing the accumulated sum of data items from the second time period that are designated as potentially indicative of an anomalous battery cell to the duration of the first time period. Normalizing the count and/or the accumulated sum of the data items that are designated as potentially indicative of an anomalous battery cell has the effect that an anomalous battery cell may be reliably distinguished from a properly functioning battery cell based on the number threshold and/or based on the total difference threshold regardless of a length of the observation window.

In an example, the first time period and/or the second time period is a static time period or a moving time period window. Additionally or alternatively the first time period and/or the second time period is adjustable. The first time period and/or the second time period being a static time period may mean that a beginning and an end of the first time period and/or of the second time period correspond to fixed points in time. This has the effect that the first data is discretely assessed in regular time intervals of equal length. The first time period and/or the second time period being a moving time period window may mean that the first time period and/or the second time period are sliding time periods having a beginning and an end that are shifted as further data items indicative of the voltage of the battery cell are obtained. More precisely, the beginning and the end of the first time period and/or of the second time period may be shifted such that the end of the first time period and/or the end of the second time period corresponds to the latest data item of the first data obtained within the method for detecting an anomalous battery cell. Consequently, the measure of the central tendency of the first data is a sliding measure of the central tendency of the first data. This has the effect that the first data is continuously being assessed as further data items of the first data are being obtained. The first time period and/or the second time period being adjustable may mean that a length of the first time period and/or of the second time period may be adjusted. More precisely, the length of the first time period and/or of the second time period may be adjusted while the method for detecting an anomalous battery cell is carried out. This has the effect that the length of the observation window may be adjusted in response to characteristics, e.g. a value or a scatter, of previous second data. In an example, the length of the observation window may be adjusted in response to a number of data items of the first data that are designated as potentially indicative of an anomalous battery cell and/or in response to a total difference of the data items of the first data that are designated as potentially indicative of an anomalous battery cell from the measure of the central tendency of the first data. Thus, anomalies of battery cells that cause erratic fluctuations in voltage of the battery cell may be reliably detected by adjusting the length of the first time period and/or of the second time period.

In an example, the method is executed during charging of the battery cell. Charging of the battery cell may be understood as charging the battery cell by a stationary charging station or as charging the battery cell by regenerative braking of a vehicle comprising the battery cell. It has been observed that distinct fluctuations in voltage of the battery cell that are indicative of anomalies of the battery cell occur during charging of the battery cell. Thus, executing the method during charging of the battery cell increases a likelihood of the method to designate an actually anomalous battery cell as anomalous. In other words, a reliable detection of anomalous battery cells may be ensured.

In an example, the method is executed after charging of the battery cell. More precisely, the method is executed directly after charging of the battery cell, i.e. without an idle time between an end of charging of the battery cell and a monitoring by the method for detecting an anomalous battery cell. In other words, this means that the method is executed over a time period that comprises a time period directly after charging of the battery cell. It is emphasized that this does not exclude that the method is also executed during charging of the battery cell. After charging of the battery cell, settling processes occur in a chemistry of the battery cell. These may be reflected in the voltage of the battery cell. Particularly a course of the voltage of the battery cell during a transition period between charging the battery cell and holding a particular level of charge may be characteristic for anomalies that may occur in the battery cell. Choosing such a time period for carrying out the method has been found to increase an anomaly detection probability of the method.

In an example, the method further comprises:
- applying a pattern recognition technique on the second data, and
- inferring the anomaly type based on an outcome of the applied pattern recognition technique.

The pattern recognition technique may assess a regularity of occurrences of data items of the first data and/or of the second data that are indicative of a potentially anomalous battery cell. Moreover, the pattern recognition technique may assess a sequence of differences between data items of the first data from the measure of the central tendency of the first data. Furthermore, the pattern recognition technique may take into account a tendency of the regularity of occurrences of data items of the second data that are indicative of a potentially anomalous battery cell. For example, data items of the second data that are indicative of a potentially anomalous battery cell may become more frequent over the time period that the battery cell is monitored by the method. This may be indicative of a soon to occur major and/or permanent failure of the battery cell. In another example, the differences between data items of the first data from the measure of the central tendency of the first data may become more prominent over the time period that the battery cell is monitored by the method. This may also be indicative of a soon to occur major and/or permanent failure of the battery cell.

According to a second aspect, there is provided a method for monitoring a battery pack of a vehicle. The battery pack comprises a plurality of battery cells. The method comprises:
- executing the method for detecting an anomalous battery cell of the first aspect for at least one battery cell of the battery pack, and
- triggering replacement of a battery cell that is designated as anomalous by a new battery cell.

Executing the method for detecting an anomalous battery cell for at least one battery cell of the battery pack may mean that at least one battery cell of the battery pack is monitored by the method for detecting an anomalous battery cell. In an example, all battery cells of the battery pack are monitored by the method for detecting an anomalous battery cell. If a battery cell is designated as anomalous by the method for detecting anomalous battery cell, replacement of that battery cell is triggered. The trigger for replacing the battery cell may comprise a warning message for a driver of a vehicle that comprises the battery pack to contact a workshop in order to have the anomalous battery cell replaced. Moreover, the trigger for replacing the battery cell may comprise an information for maintenance personnel which battery cell of the battery pack was designated to be anomalous. Additionally or alternatively, the trigger for replacement can be or comprise a fault code set in a control unit associated with the battery pack and/or the battery cell, e.g. the battery management system. Such a fault code may inform the driver depending on the severity of the detected anomalous cell. If the anomalous deviation is considered severe, that may restrict the driver from charging or other mitigations to reduce risk before the vehicles is serviced. Altogether, the triggering has the effect that the battery cell may be replaced in a timely and targeted manner. Moreover, a spread of the anomaly to further battery cells of the battery pack, e.g. to neighboring battery cells of the anomalous battery cell through electric and/or thermal coupling, may be avoided.

The method according to the first aspect and the method according to the second aspect may be at least partly computer-implemented, and may be implemented in software or in hardware, or in software and hardware. Further, the methods may be carried out by computer program instructions running on means that provide data processing functions. The data processing means may be a suitable computing means, such as an electronic control module etc., which may also be a distributed computer system. The data processing means or the computer, respectively, may comprise one or more of a processor, a memory, a data interface, or the like.

According to a third aspect, there is provided a data processing apparatus comprising means for carrying out the methods of the first aspect and/or of the second aspect. Providing such a data processing apparatus has the effect that predictive maintenance of a battery cell, in particular of a plurality of battery cells of a battery pack may be conducted. This means that anomalous battery cells may not only be detected when they have reached a major and/or a permanent failure but already when such a failure is looming and is reflected in a course of the voltage of the battery cell. This further means that anomalous battery cells may not only be replaced when they have reached a major and/or a permanent failure but already when such a failure is looming and is reflected in a course of the voltage of the battery cell. In case the battery pack is comprised in a vehicle, the data processing apparatus may form part of the vehicle. However, the data processing apparatus may also be external to the vehicle, for example, the data processing apparatus may be provided on an external cloud server. Also, the data processing apparatus may be a distributed data processing apparatus that is located partly in the vehicle and partly on the external cloud server. This may have the effect that not the entire first data, which may be large amounts of data, need to be transmitted to the external cloud server. Instead, the first data may be condensed into the form of the second data in the data processing apparatus located in the vehicle. Only the condensed second data, which may be a significantly smaller amount of data than the first data, may have to be transmitted to the external cloud server. On the external cloud server, an analysis of the second data, for example a pattern recognition, may be carried out. This may be advantageous because an external cloud server may be able to provide more computational power for analyzing the second data than a data processing apparatus located on the vehicle.

According to a fourth aspect, there is provided a computer program comprising instructions which, when the computer program is executed by a computer, cause the computer to carry out the methods of the first aspect and/or of the second aspect. Providing such a computer program has the effect that predictive maintenance of a battery cell, in particular of a plurality of battery cells of a battery pack may be conducted. This means that anomalous battery cells may not only be detected when they have reached a major and/or a permanent failure but already when such a failure is looming and is reflected in a course of the voltage of the battery cell. This further means that anomalous battery cells are may not only be replaced when they have reached a major and/or a permanent failure but already when such a failure is looming and is reflected in a course of the voltage of the battery cell. In case the battery pack is comprised in a vehicle, the computer program may be executed on the vehicle. Alternatively, the computer program may be executed on an external cloud server. Further alternatively, the computer program may be a distributed computer program that is partly executed on the vehicle and partly executed on the external cloud server.

According to a fifth aspect, there is provided a computer-readable storage medium comprising instructions which, when executed by a computer, cause the computer to carry out the methods of the first aspect and/or of the second aspect. Providing such a computer-readable storage medium has the effect that predictive maintenance of a battery cell, in particular of a plurality of battery cells of a battery pack may be conducted. This means that anomalous battery cells may not only be detected when they have reached a major and/or a permanent failure but already when such a failure is looming and is reflected in a course of the voltage of the battery cell. This further means that anomalous battery cells are may not only be replaced when they have reached a major and/or a permanent failure but already when such a failure is looming and is reflected in a course of the voltage of the battery cell. In case the battery pack is comprised in a vehicle, the computer-readable storage medium may be provided in the vehicle. Alternatively, the computer-readable storage medium may be provided on an external cloud server. Further alternatively, a computer-readable storage medium may be provided both on the vehicle and on the external server.

According to a sixth aspect, there is provided a vehicle comprising a data processing apparatus according to the third aspect. The vehicle comprises at least one battery cell that is monitored by the data processing apparatus using the method according to the first aspect and/or the method according to the second aspect. Thus, the data processing apparatus is configured to obtain first data comprising a plurality of data items indicative of a voltage of the at least one battery cell within a first time period. In an example, the vehicle comprises a battery pack having a plurality of battery cells that are monitored by the data processing apparatus using the method according to the first aspect and/or the method according to the second aspect. This has the effect that predictive maintenance of the at least one battery cell or of the entire battery pack of the vehicle may be conducted. Conducting predictive maintenance comes with the advantage that anomalous battery cells are not only detected when they have reached a major and/or a permanent failure but already prior to the major and/or prior to the permanent failure. This increases an availability of the vehicle for a user of the vehicle and reduces a rate of vehicle breakdowns in a fleet of vehicles that comprise the data processing apparatus.

It should be noted that the above examples may be combined with each other irrespective of the aspect involved.

These and other aspects of the present disclosure will become apparent from and elucidated with reference to the examples described hereinafter.

### BRIEF DESCRIPTION OF DRAWINGS

Examples of the disclosure will be described in the following with reference to the following drawings.
- Figure 1: shows a vehicle according to the present disclosure, the vehicle comprising a data processing apparatus according to the present disclosure for carrying out a method according to the present disclosure for detecting an anomalous battery cell and for carrying out a method according to the present disclosure for monitoring a battery pack,
- Figure 2: shows a diagram of first data comprising a plurality of data items indicative of a voltage of a battery cell of the traction battery of the vehicle of Figure 1 over time, wherein a margin for designating a data item of the first data as potentially indicative of an anomaly is an absolute voltage threshold,
- Figure 3: shows a histogram of absolute differences between data items of the first data and a central tendency of the first data,
- Figure 4: shows a histogram of occurrences of data items in the first data that are potentially indicative of an anomalous battery cell,

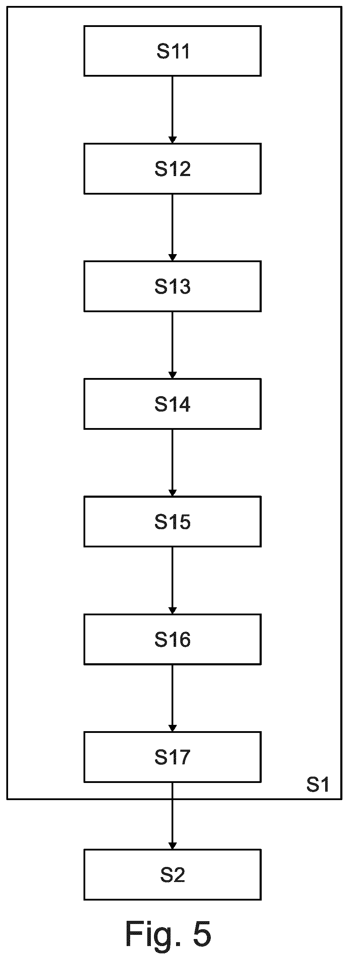

- Figure 5: shows steps of the first method and of the second method,
- Figure 6: shows the diagram of Figure 2 but wherein the margin for designating a data item of the first data as potentially indicative of an anomaly is an absolute margin relative to a central tendency of the first data within a first time period,
- Figure 7: shows the diagram of Figure 7 but wherein the first time period and a second time period that comprises the first time period and that is longer than the first time period are moving time period windows.

### DETAILED DESCRIPTION

The Figures are merely schematic representations and serve only to illustrate examples of the disclosure. Identical or equivalent elements are in principle provided with the same reference signs.

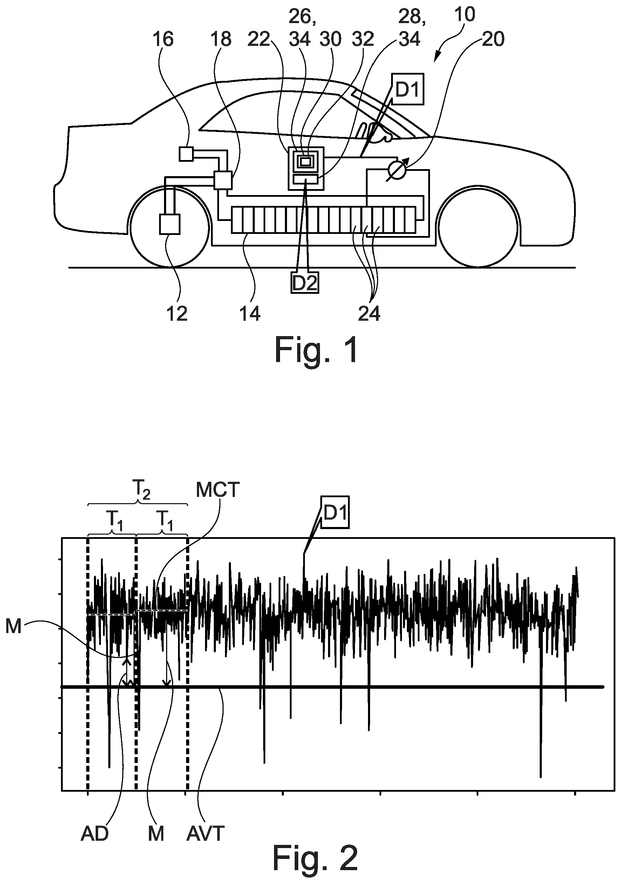

Figure 1 shows a vehicle 10.

The vehicle 10 comprises an electric machine 12, a traction battery pack 14, a charging socket 16 and a rectifier/inverter unit 18.

The traction battery pack 14 may be charged by providing charging current to the traction battery pack 14 via the charging socket 16 and, in case of AC charging, via a rectifier of the rectifier/inverter unit 18. Electric energy stored in the traction battery pack 14 may be provided to the electric machine 12 of the vehicle 10 via an inverter unit of the rectifier/inverter unit 18 in order to drive the vehicle 10.

The vehicle 10 further comprises a voltmeter 20 and a data processing apparatus 22. Moreover, the traction battery pack 14 of the vehicle 10 comprises a plurality of battery cells 24.

In the illustration of Figure 1, the voltmeter 20 is electrically connected to one battery cell 24 of the traction battery pack 14 in order to provide first data D1 indicative of a voltage of the battery cell 24. However, it is noted that this is only for reasons of the ease of representation. Of course, it is conceivable that the voltmeter 20 may be electrically connected to each of the battery cells 24 of the traction battery pack 14 in order to determine first data indicative of a voltage of each battery cell 24. Alternatively, one voltmeter may be provided per battery cell 24.

The voltmeter 20 is communicatively connected to the data processing apparatus 22. Thus, first data D1 from the voltmeter is provided to the data processing apparatus 22 and is, thus, received at the data processing apparatus 22.

The data processing apparatus 22 comprises a data storage unit 26 and a data processing unit 28. The data storage unit 26 comprises a computer-readable storage medium 30. On the computer-readable storage medium 30, there is provided a computer program 32.

The computer program 32 and, thus, also the computer-readable storage medium 30, comprise instructions which, when executed by the data processing unit 28, or, more generally speaking, a computer, cause the computer or the data processing unit 28 to carry out a method for detecting an anomalous battery cell 24. The method for detecting an anomalous battery cell 24 may be referred to as a first method.

Moreover, the computer program 32 and, thus, also the computer-readable storage medium 30, comprise instructions which, when executed by the data processing unit 28, or, more generally speaking, a computer, cause the computer or the data processing unit 28 to carry out a method for monitoring a battery pack 14. The method for monitoring a battery pack 14 may be referred to as a second method. The first method forms part of the second method, as will be explained in the following.

Thus, it may be said that the data storage unit 26 and the data processing unit 28 form means 34 for carrying out the first method and means 34 for carrying out the second method.

In the present example, the first method is executed while the traction battery pack 14 and, thus, the battery cell 24 that is being monitored by the voltmeter 20 is being charged. Moreover, the first method is executed beyond an end of charging of the traction battery pack 14 and of the battery cell 24. Thus, a time period during which the first method is executed covers a transition period between charging of the traction battery pack 14 and holding the traction battery pack 14 at a specific level of charge.

A first step S11 of the first method comprises obtaining the first data D1 from the voltmeter 20 within a first time period T1. More precisely, a plurality of data items of the first data D1 are obtained from the voltmeter 20 within the first time period T1.

Figure 2 shows a diagram of the first data D1 over time. The first data D1 has been obtained over a plurality of first time periods T1. In the diagram of Figure 2, the first time periods T1 are separated by vertical dashed lines. Each first time period T1 of the plurality of first time periods T1 has the same length. Moreover, each first time period T1 of the plurality of first time periods T1 is a static first time period T1. This means that a beginning and an end of each first time period T1 are fixed points in time.

A second step S12 of the first method comprises obtaining a measure of a central tendency MCT of the first data D1 over each of the first time periods T1. In the present example, the measure of the central tendency MCT of the first data D1 is an arithmetic mean of data items of the first data D1 within a first time period T1. In other words, the arithmetic mean of data items of first data D1 is determined independently for each first time period T1 over which the first data has been obtained. Thus, each first time period T1 yields an arithmetic mean that is independent from an arithmetic mean of the other first time periods T1.

A third step S13 of the first method comprises designating a data item of the first data D1 as potentially indicative of an anomaly of the battery cell 24 that the first data D1 originates from. A particular data item is designated as potentially indicative of an anomaly if an absolute difference AD between the particular data item and the arithmetic mean of the first time period T1 that the particular data item originates from is greater than or equal to a margin M.

In the present example, the margin M is predefined.

In the present example of Figure 2, the margin M is defined as the arithmetic mean of the first data D1 during a first time period T1 minus an absolute voltage threshold AVT. The absolute voltage threshold AVT is inferior to the arithmetic mean of the first data D1. In other words, a voltage drop below the absolute voltage threshold AVT is considered as a data item of the first data D1 that is potentially indicative of an anomaly of the battery cell 24.

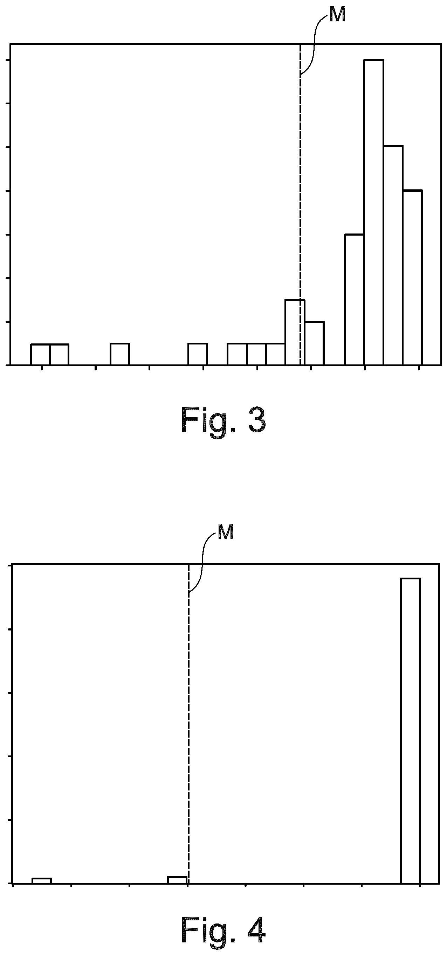

Figure 3 shows a histogram of differences between data items of the first data D1 and the arithmetic mean of the first time period T1 that the data items originate from. Only differences of data items to the arithmetic mean are shown that are based on data items that lie below the arithmetic mean. In other words, Figure 3 shows a left half of a distribution of differences between data items of the first data D1 and the arithmetic mean. The histogram shows bins of ranges of the differences on the x-axis and absolute numbers of occurrences for each bin on the y-axis.

Figure 4 also shows a histogram of differences between data items of the first data D1 and the arithmetic mean of the first time period T1 that the data items originate from. However, the differences have been filtered by the margin M. If a difference is inferior to the margin M, it is assigned into the bin adjacent to zero. Only if a difference is equal to or greater than the margin M, the difference remains in its original bin. Only differences that have remained in their original bin are designated as potentially indicative of an anomalous battery cell 24 and are counted and summed up, as will be explained in the following in connection with a fourth step S14 of the first method. It is to be noted that the diagram in Figure 4 is based on a different set of first data D1 than the diagram in Figure 3.

In the fourth step S14 of the first method, a number of data items that are designated as potentially indicative of an anomaly of the battery cell 24 are counted over a second time period T2. In the present example, a second time period T2 comprises two consecutive first time periods T1. Since, in the present example, the first time periods T1 are static time periods, also the second time period T2 is a static time period. The number of data items that are designated as potentially indicative of an anomaly of the battery cell 24 may be referred to as second data D2.

Additionally, all differences of data items from the arithmetic mean of a first time period T1 that are greater than or equal to the margin M are summed up over the second time period T2. In other words, all differences of data items from the arithmetic mean of a first time period T1 that are greater than or equal to the margin M are accumulated over the second time period T2. Also the summed up, i.e. the accumulated, differences of data items from the arithmetic means of the first time periods T1 within the second time period T2 may be designated as second data D2.

In the present example, the second time period T2 covers two consecutive first time periods T1. However, the second time period T2 may cover any number of consecutive first time periods T1. In order to be able to compare second data D2 that is obtained over second time periods T2 of different lengths, a reduction factor is applied to the second data D2, i.e. to the number of data items that are designated as potentially indicative of an anomaly of the battery cell 24 and to the summed up differences of data items from the arithmetic mean of a first time period T1 that are greater than or equal to the margin M.

The reduction factor is directly proportional to a relation between a length of the first time period T1 and a length of the second time period T2. Since, in the present example, the second time period T2 comprises to first time periods T1 of equal length, the reduction factor is 1/2.

In a fifth step S15 of the first method, the battery cell 24 is designated as an anomalous battery cell 24 if the second data D2, more precisely the number of data items that are designated as potentially indicative of an anomaly multiplied by the reduction factor, exceeds a number threshold and if the second data D2, more precisely the accumulated difference multiplied by the reduction factor, exceeds a total difference threshold. Of course, it would also be conceivable to designate the battery cell 24 as anomalous either if the number of data items that are designated as potentially indicative of an anomaly multiplied by the reduction factor exceeds the number threshold or if the accumulated difference multiplied by the reduction factor exceeds the total difference threshold.

In a sixth step S16 of the first method, the number threshold and the total difference threshold are varied as further first data D1 from further first time periods T1 is obtained by the data processing apparatus as an observation of the battery cell 24 continues. Depending on the configuration of the number threshold and the total difference threshold, different anomaly types of the battery cell 24 may be distinguished. Anomaly types of the battery cell 24 may comprise tabs connected to cathode layers or to anode layers of the battery cell that are torn. A further anomaly may comprise a failure of a measurement node that measures a current, the voltage and/or a temperature of the respective battery cell 24. Moreover, anomalies in the chemistry of the battery cell such as an amount of lithium plating of its electrodes or a capacity of how much lithium the cathode can supply and how much lithium the anode can take up deviating from a norm may be a form of an anomaly of the battery cell 24 that may be distinguished by varying the number threshold and/or the total difference threshold. Also, electric shortcuts in the battery cell 24, for example due to penetration by an external physical solid may be discernible from other anomalies of the battery cell 24 by varying the number threshold and/or the total difference threshold. However, it is noted that it may only be possible to narrow down the anomaly type to a group of different anomaly types by varying the number threshold and the total difference threshold.

In order to distinguish a particular anomaly type of the battery cell 24, a pattern recognition technique is applied to the second data D2 in a seventh step S17 of the first method. In the present example, the pattern recognition technique recognizes if the number of data items that are designated as potentially indicative of an anomalous battery cell 24 increases, reduces or substantially remains the same as further first data D1 from further first time periods T1 is obtained. Moreover, the pattern recognition technique recognizes if the accumulated difference increases, reduces or substantially remains the same over the second time periods T2 as further first data D1 is obtained. Thus, after the seventh step S17, the first method provides a concrete anomaly type of the battery cell 24 as an output.

In the following, the second method for monitoring a battery pack 14, here the traction battery pack 14 of the vehicle 10, will be explained.

A first step S1 of the second method comprises executing the first method as explained above.

In a second step S2 of the second method, replacement of a battery cell 24 that is designated as anomalous by a new battery cell 24 is triggered. In the present example, the triggering comprises a warning message for a user of the vehicle 10 that is displayed to the user in the interior of the vehicle 10 and via a smartphone app that the user of the vehicle 10 has installed on his or her smartphone. Moreover, the triggering comprises an information for workshop personnel which battery cells 24 of the traction battery pack 14 is anomalous and, consequently, needs to be replaced.

Further, it is conceivable to have the point in time at which the replacement of the battery cell 24 is triggered is dependent on the outcome of the pattern recognition technique applied in the first method. For example, the triggering may be caused immediately if the anomaly of the battery cell 24 appears to worsen, i.e. if the number of data items that are designated as potentially indicative of an anomalous battery cell 24 increases over consecutive second time periods T2 or if the accumulated difference increases over consecutive second time periods T2. By contrast, the triggering may be caused with a time delay if the anomaly of the battery cell 24 appears to not further progress, i.e. if the number of data items that are designated as potentially indicative of an anomalous battery cell 24 decreases or substantially remains the same over consecutive second time periods T2 or if the accumulated difference decreases or substantially remains the same increases over consecutive second time periods T2. In simplified words, the second method may derive an urgency for triggering the replacement of the anomalous battery cell 24 based on a trend in the first data D1 and/or in the second data D2. Moreover, the second method may define the urgency for triggering the replacement of the anomalous battery cell 24 based on the distinguished anomaly type of the battery cell 24.

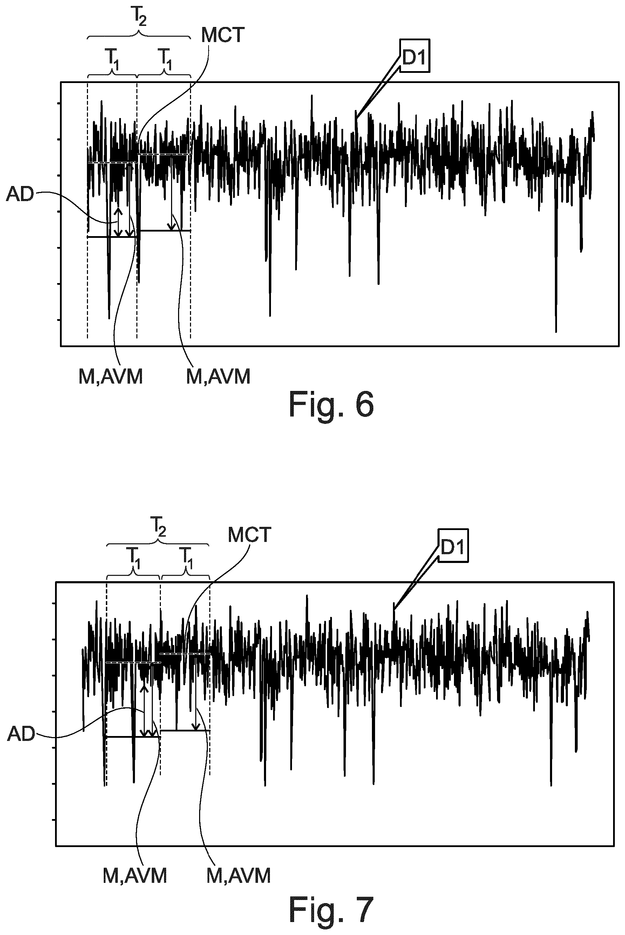

The diagram in Figure 6 shows the same first data D1 as the diagram in figure 2. Only the differences with respect to the diagram in Figure 2 will be explained.

In the diagram in Figure 6, the margin M is not defined by the arithmetic mean of the first data D1 within a first time period T1 minus an absolute voltage threshold AVT. Instead, the margin M is defined as an absolute voltage margin AVM relative to the arithmetic mean of the first data D1 within a first time period T1. Thus, the threshold that a data item of the first data D1 needs to reach or fall below in order to be designated as potentially indicative of an anomalous battery cell 24 is not a constant absolute voltage threshold AVT but a dynamic voltage threshold that may change between different first time periods T1.

The diagram in Figure 7 shows the same first data D1 as the diagram in Figures 2 and 6. Only the differences with respect to the diagrams in Figures 2 and 6 will be explained.

The diagram in Figure 7 shows a variant of the first method in which the first time period T1 and the second time period T2 are moving time period windows. It can be observed that the two first time periods, which are drawn-in as a vertical dashed lines and which define the second time period T2, are shifted further towards the right of the x-axis relative to the diagram in Figure 6. This is to be understood in that as more data items of first data D1 are being obtained, the first time periods T1 and, thus, also the second time period T2 is moved along the x-axis in the diagram at the rate at which further data items of the first data D1 are being obtained. This means that the arithmetic mean of the first data D1 of a first time period T1 is a moving arithmetic mean of the first data D1.

In summary, monitoring the traction battery pack 14 of the vehicle 10 by means of the explained first method and second method enables a predictive maintenance of the traction battery pack 14. This means that battery cells 24 of the traction battery pack 14 can be replaced only when needed, i.e. if a particular battery cell 24 is designated as anomalous. This reduces maintenance effort and reduces the likelihood of the traction battery pack 14 of the vehicle 10 to suffer from a major and/or a permanent failure while the vehicle 10 is being used by the user. This increases a reliability of the traction battery pack 14 during use of the vehicle 10.

As used herein, the phrase "at least one," in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a non-limiting example, "at least one of A and B" (or, equivalently, "at least one of A or B," or, equivalently "at least one of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. A computer program may be stored/distributed on a suitable medium such as an optical storage medium or a solid-state medium supplied together with or as part of other hardware, but may also be distributed in other forms, such as via the Internet or other wired or wireless telecommunication systems. Any reference signs in the claims should not be construed as limiting the scope of the claims.

### LIST OF REFERENCE SIGNS

- 10: vehicle
- 12: electric machine
- 14: battery pack
- 16: charging socket
- 18: rectifier/inverter unit
- 20: voltmeter
- 22: data processing apparatus
- 24: battery cell
- 26: data storage unit
- 28: data processing unit
- 30: computer-readable storage medium
- 32: computer program
- 34: means for carrying out first method and second method

- AD: absolute difference
- AVT: absolute voltage threshold
- AVM: absolute voltage margin
- D1: first data
- D2: second data
- M: margin
- MCT: measure of central tendency
- T1: first time period
- T2: second time period

## Claims

1. A method for detecting an anomalous battery cell (24) in a vehicle (10), the method comprising:
- obtaining first data (D1) comprising a plurality of data items indicative of a voltage of the battery cell (24) within a first time period (T1),
- obtaining a measure of a central tendency (MCT) of the first data (D1),
- designating a data item of the first data (D 1) as potentially indicative of an anomaly if an absolute difference (AD) between the data item and the measure of the central tendency (MCT) is greater than or equal to a margin (M),
- obtaining second data (D2) indicative of a number of data items associated with the first time period (T1) that are designated as potentially indicative of an anomalous battery cell (24) and/or indicative of a total difference of the data items differing from the measure of the central tendency (MCT) by at least the margin (M), and
- designating the battery cell (24) as anomalous if the second data (D2) exceeds a number threshold and/or a total difference threshold.

2. The method according to claim 1, wherein the measure of the central tendency (MCT) of the first data (D1) comprises an arithmetic mean, a geometric mean and/or a median of the first data (D1).

3. The method according to claim 1 or 2, wherein the margin (M) is defined as an absolute voltage margin (AVM), as a voltage margin relative to the measure of the central tendency (MCT) of the first data (D1) and/or as a voltage margin relative to a scatter in the first data (D1).

4. The method of any one of the preceding claims, further comprising varying the number threshold and/or the total difference threshold for detecting different anomaly types.

5. The method according to any of the preceding claims, wherein the second data (D2) is accumulated over a second time period (T2), wherein the second time period (T2) is longer than the first time period (T1).

6. The method according to claim 5, wherein the accumulation comprises an application of a reduction factor.

7. The method according to claim 6, wherein the reduction factor is proportional to a relation of a duration of the first time period (T1) and a duration of the second time period (T2).

8. The method according to any of the preceding claims, wherein the first time period (T1) and/or the second time period (T2) is a static time period or a moving time period window, and/or
wherein the first time period (T1) and/or the second time period (T2) is adjustable.

9. The method according to any of the preceding claims, wherein the method is executed during charging of the battery cell (24).

10. The method according to any one of the preceding claims, further comprising:
- applying a pattern recognition technique on the second data (D2), and
- inferring the anomaly type based on an outcome of the applied pattern recognition technique.

11. A method for monitoring a battery pack (14) of a vehicle (10), the battery pack (14) comprising a plurality of battery cells (24), the method comprising:
- executing the method for detecting an anomalous battery cell (24) of claims 1 to 10 for at least one battery cell (24) of the battery pack (14), and
- triggering replacement of a battery cell (24) that is designated as anomalous by a new battery cell (24).

12. A data processing apparatus (22) comprising means (34) for carrying out the methods of any one of the preceding claims.

13. A computer program (32) comprising instructions which, when the computer program (32) is executed by a computer, cause the computer to carry out the methods of claims 1 to 11.

14. A computer-readable storage medium (30) comprising instructions which, when executed by a computer, cause the computer to carry out the methods of claims 1 to 11.

15. A vehicle (10) comprising a data processing apparatus (22) according to claim 12 and at least one battery cell (24), wherein the data processing apparatus (24) is configured to obtain first data (D1) comprising a plurality of data items indicative of a voltage of the at least one battery cell (24) within a first time period (T1).
